# EUROPÄISCHE PATENTSCHRIFT

(11) **EP 0 390 061 B1**
(45) Veröffentlichungstag und Bekanntmachung des Hinweises auf die Patenterteilung: **24.01.1996**
(21) Anmeldenummer: 90105776.0
(22) Anmeldetag: 27.03.1990
(51) Int. Cl.: H01L 27/15, H01L 33/00

(54) **Verfahren zur Herstellung monolithisch integrierter optoelektronischer Module**
Method for the production of monolithically integrated optoelectronic modules
Procédé pour la fabrication d'un module opto-électronique monolithiquement intégré

(30) Priorität: 30.03.1989 DE 3910288
(43) Veröffentlichungstag der Anmeldung: 03.10.1990
(73) Patentinhaber: Alcatel SEL Aktiengesellschaft, D-70435 Stuttgart (DE); ALCATEL N.V., NL-1077 XX Amsterdam (NL)
(72) Erfinder: Tegude, Franz-Josef, Dr., D-7015 Korntal-Münchingen 1 (DE)
(74) Vertreter: Pohl, Herbert, Dipl.-Ing

(56) Entgegenhaltungen:
- EP-A- 0 061 938
- EP-A- 0 188 080
- US-A- 4 523 212
- US-A- 4 566 171

## Beschreibung

Die Erfindung betrifft ein Verfahrer zur Herstellung integrierter optoelektronischer Module, insbesondere solcher auf der Basis von III/V-Verbindungshalbleitern.

Die optische Nachrichtenübertragung ermöglicht sehr große Datenübertragungsraten in der Größenordnung von 10 bis 20 Gigabit/Sekunde. Datenübertragungsraten dieser Größenordnung stellen hohe Anforderungen an die sende- und empfangsseitig eingesetzten optoelektronischen und elektronischen Komponenten. U.a. begrenzen unerwünschte Kapazitäten auf der Sence- und Empfangsseite und lange Verbindungswege zwischen Ansteuerelektronik und optoelektronischem Bauelement die Übertragungsrate. Eine Möglichkeit, den Einfluß unerwünschter Kapazitäten und lange Verbindungswege zu vermindern, besteht darin, das optoelektronische Bauelement, beispielsweise eine Laserdiode oder ein Detektor, und die zugehörige Elektronik monolithisch auf einem Halbleiter-Substrat zusammenzufassen. Die Herstellung solcher Module erfordert eine Reihe von Verfahrensschritten, wie z.B. das Abscheiden verschiedener Halbleiterschichten und die Passivierung und elektrische Trennung der einzelnen elektronischen und optoelektronischen Bauelemente. Bestimmte Epitaxieverfahren führen zu nicht planaren Waferoberflächen. Auf solchen unebenen Oberflächen lassen sich wegen der Unebenheiten nur schwer weitere Mikrostrukturen photolithographisch erzeugen. Aus der US-A-4 566 171 ist ein Verfahren zur Herstellung eines vergrabenen Heteroübergangs lasers mit lateralen dotierten InP-Begrenzungsschichten bekannt, die epitaktisch und koplanar auf ein Substrat mit einer Mesastruktur aufgewachsen sind. Aufgabe der Erfindung ist es, ein kostengünstiges, aus wenigen Schritten bestehendes Verfahren zur Herstellung integrierter optoelektronischer Module anzugeben, das die problemlose Anwendung lithographischer Prozesse zur Mikrostrukturierung erlaubt und eine sichere elektrische Trennung der Einzelkomponenten ermöglicht. Gelöst wird diese Aufgabe durch ein Verfahren mit der Merkmalskombination des Hauptanspruches.

Das erfindungsgemäße Verfahren hat den Vorteil, daß durch die selektive Abscheidung epitaktischer Schichten planare Waferoberflächen erzeugt werden, die zu einer Vereinfachung der Prozeßführung für die Mikrostrukturierung führen. Ein weiterer Vorteil liegt in der Verwendung semi-isolierenden Indiumphosphidmaterials, das einerseits zu einer guten Passivierung der einzelnen Bauelemente, andererseits zu einer guten elektrischen Trennung der Bauelemente voneinander führt. Ein weiterer Vorteil der Erfindung ergibt sich dann, wenn anstelle eines semi-isolierenden Substrates ein n-InP-dotiertes Grundmaterial benutzt wird. Die darauf abgeschiedenen epitaktischen Schichten haben eine bessere Kristallqualität als die auf semi-isolierendem Indiumphosphidsubstrat abgeschiedenen.

Die elektrische Trennung der optoelektronischen Komponenten von der Elektronik erfolgt durch epitaktisch abgeschiedenes semi-isolierendes Indiumphosphid. Ein weiterer Vorteil des erfindungsgemäßen Verfahrens liegt in der hohen Flexibilität bei der Konzeption der monolithischen Integration.

Ein Beispiel für die Anwendung des Verfahrens wird im folgenden beschrieben und anhand der Figuren 1 bis 6 näher erläutert. Es zeigen:
- Fig. 1: eine erste Schichtenfolge auf einem Halbleitersubstrat oder auf n-dotiertem Indiumphosphid,
- Fig. 2: die geätzte Schichtstruktur nach Fig. 1 mit dielektrischer Ätzmaske,
- Fig. 3: die selektive Epitaxie von semi-isolierendem Halbleitermaterial,
- Fig. 4: optoelektronisches Bauelement, semi-isolierendes Halbleitermaterial und eine zweite Ätzmaske,
- Fig. 5: die durch selektive Epitaxie aufgebrachte Schichtenfolge für elektronische Bauelemente,
- Fig. 6: ein Hetero-Bipolartransistor auf dem semi-isolierenden Grundmaterial.

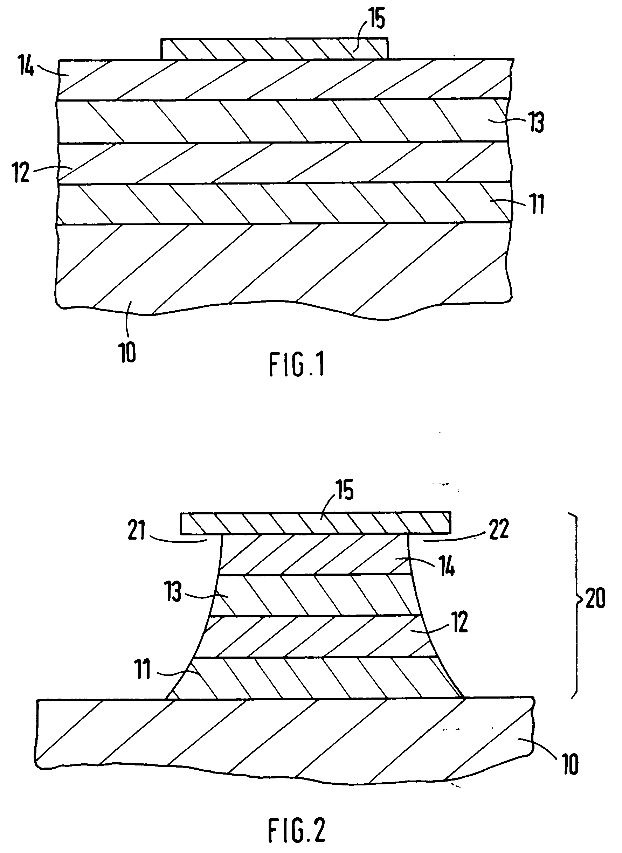

Fig. 1 zeigt einen Ausschnitt aus einem Halbleiterwafer. Mit 10 ist ein Halbleitersubstrat bezeichnet, auf das eine Folge von verschiedenen Halbleiterschichten epitaktisch aufgewachsen ist. 11 bezeichnet eine n-dotierte InP-Schicht, 12 eine als aktive Schicht dienende InGaAsP-Schicht, 13 eine p-dotierte InP-Schicht und 14 eine p-dotierte InGaAs-Schicht. Mit 15 ist eine dielektrische Ätzmaske gekennzeichnet, die beispielsweise aus Silizium-Dioxid besteht. Die Ätzmaske 15 deckt die Halbleiterschichtenfolge ab. Unter der Ätzmaske 15 soll später ein optoelektronisches Bauelement entstehen. Die verschiedenen Halbleiterschichten sind entweder mittels metallorganischer Gasphasenepitaxie (MOVPE) oder mittels Flüssigphasenepitaxie (LPE) abgeschieden worden. Anstelle des mit 10 bezeichneten Halbleitersubstrates kann auch ein n-dotiertes InP-Substrat verwendet werden. Die Begründung dafür wird im weiteren Verlauf der Beschreibung noch gegeben.

Durch geeignete Ätzmittel sollen die nicht von der Ätzmaske 15 bedeckten Halbleiterschichten abgeätzt werden. Es ergibt sich eine mesaförmige Schichtstruktur nach Fig. 2. Die einzelnen Halbleiterschichten 11 bis 14 sind wieder zu erkennen. Mit 21 und 22 sind Teile der dielektrischen Ätzmaske bezeichnet, die über das Halbleitermaterial hinausragen. Durch diese Überhänge werden Randüberwachsungen beim weiteren epitaktischen Abscheiden anderer Halbleiterschichten vermieden. Auf diese Weise entstehen sehr ebene Waferoberflächen, wie sie für eine Mikrostrukturierung mit Hilfe lithographischer Prozesse erforderlich sind.

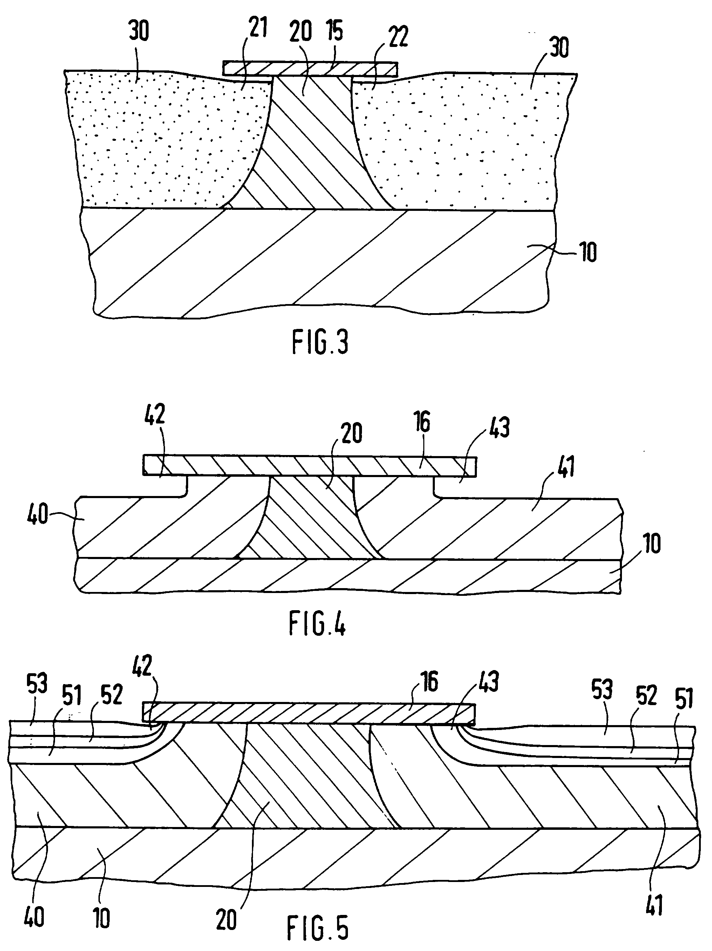

In Fig. 3 ist mit 20 die mesaförmige Schichtstruktur nach Fig. 2 bezeichnet. Diese mesaförmige Schichtstruktur ist mit der Ätzmaske 15 abgedeckt. Um die mesaförmige Schichtstruktur 20 befinden sich mit 30 gekennzeichnete Bereiche, die aus semi-isolierendem InP bestehen. An den Überhängen 21 und 22 sind keine Randüberwachsungen entstanden. Das semi-isolierende Halbleitermaterial 30 dient zur Passivierung des optoelektronischen Bauelementes 20 und soll gleichzeitig das optoelektronische Bauelement von einer später noch aufzubringenden Elektronik trennen. Aus diesem Grunde muß die Schichtenfolge 20 von semi-isolierendem InP-Material umgeben sein. Dazu wird die dielektrische Ätzmaske 15 durch eine etwas breitere Ätzmaske ersetzt, und anschließend wird der gesamte Wafer geätzt. Das Ergebnis des Ätzprozesses ist in Fig. 4 dargestellt. 16 bezeichnet die verbreiterte dielektrische Ätzmaske. Die Schichtenfolge 20 ist von semi-isolierendem InP umgeben. Die InP-Streifen sind mit 40 und 41 gekennzeichnet. Mit 42 und 43 sind Überhänge der dielektrischen Ätzmaske bezeichnet. Durch selektive Epitaxie werden auf die Struktur nach Fig. 4 weitere Halbleiterschichten abgeschieden, die für die Herstellung elektronischer Bauelemente erforderlich sind. Durch die Überhänge 42 und 43 wird sichergestellt, daß an den Rändern keine Randüberwachsungen entstehen. Die Art der aufgebrachten Halbleiterschichten hängt davon ab, welche elektronischen Bauelemente realisiert werden sollen. In Fig. 5 ist eine Schichtstruktur für einen Heterobipolartransistor wiedergegeben, der aus einer n-dotierten Schicht 51, aus einer p-dotierten Schicht 52 und aus einer n-dotierten Schicht 53 besteht. Andere Schichtstrukturen, wie sie beispielsweise für Feldeffekttransistoren erforderlich sind, sind denkbar. Die Streifen 40 und 41 aus semi-isolierendem InP dienen einerseits dazu, die Schichtenfolge 20, mit anderen Worten das optoelektronische Bauelement, zu passivieren und andererseits eine elektrische Isolation zwischen optoelektronischem Bauelement und Halbleiterbauelement herzustellen. Das Substrat 10 dient damit nicht der elektrischen Isolation der einzelnen Bauelemente voneinander. Aus diesem Grunde kann anstelle eines semi-isolierenden Substrates ein n-dotiertes InP-Substrat benutzt werden. Der Vorteil bei der Verwendung eines n-dotierten InP-Substrates liegt darin, daß die darauf abgeschiedenen Halbleiterschichten eine bessere Kristallstruktur haben als solche, die auf semi-isolierendem Substrat abgeschieden werden.

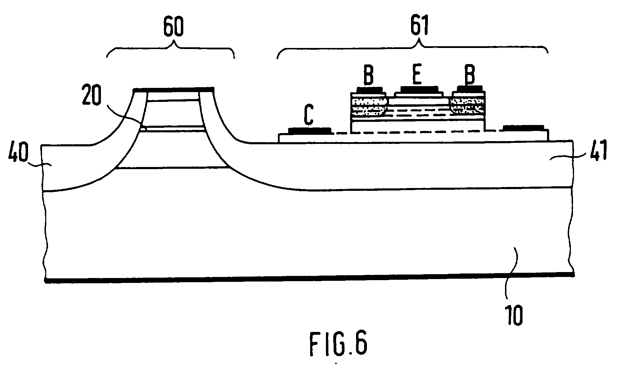

In Fig. 6 ist ein fertiges optoelektronisches Modul dargestellt. Mit 60 ist ein Bereich bezeichnet, der das optoelektronische Bauelement, entweder eine Laserdiode oder einen Detektor, enthält. Dieser Bereich 60 ist von den semi-isolierenden InP-Schichten 40 und 41 umgeben. Auf dem Streifen 41 ist eine mit 61 bezeichnete Halbleiterstruktur aufgebracht, die ein elektronisches Bauelement repräsentiert. Laser 60 und elektronisches Bauelement 61 sind durch das semi-isolierende Material 41 elektrisch voneinander getrennt.

Die Herstellung der elektronischen Bauelemente wird nicht im Detail beschrieben, da sie nicht Gegenstand der Erfindung ist. Dem Fachmann auf dem Gebiet der Halbleitertechnologie sind die einzelnen Verfahren geläufig und werden daher als bekannt vorausgesetzt.

## Patentansprüche

1. Verfahren zur Herstellung monolithisch integrierter, insbesondere optoelektronischer Module aus III/V-Verbindungshalbleitern, auf denen sich erste und zweite elektronische Bauelemente (60, 61) befinden, das folgende Verfahrensschritte aufweist :
a) Ganzflächiges epitaktisches Abscheiden einer ersten Halbleiterschichtenfolge (11-14) für erste elektronische Bauelemente auf einem semi-isolierenden oder leitenden InP-Substrat (10);
b) Herstellen einer ersten elektronischen Bauelements durch Abdecken eines Teilbereiches der ersten Halbleiterschichtenfolge (11-14) mit einer ersten dielektrischen Schicht (15), und
c) Wegätzen des nicht abgedeckten Bereiches der ersten Halbleiterschichtenfolge (11-14) bis auf eine unter der ersten dielektrischen Schicht (15) zurückbleibende mesaförmige Schichtstruktur (20), wobei die erste dielektrische Schicht Überhänge (21, 22) bildet;
d) selektives epitaktisches Abscheiden einer semi-isolierenden InP-Schicht (30) mit der ersten dielektriscten Schicht (15) als Maske, bis die InP-Schicht (30) und die mesaförmige Schichtstruktur (20) des ersten Teilbereichs eine ebene Oberfläche bilden;
e) Abdecken des ersten Teilbereiches mit einer zweiten dielektrischen Schicht (16), die über den ersten Teilbereich ein bestimmtes Stück übersteht;
f) Teilweises Wegätzen der nicht abgedeckten semi-isolierenden InP-Schicht (30) bis auf zurückbleibende InP-Streifen (40, 41) mit ebener Oberfläche, wobei die zweite dielektrische Schicht Überhänge (42, 43) bildet;
g) selektives epitaktisches Abscheiden einer zweiten Halbleiterschichtenfolge (51-53) für zweite elektronische Bauelemente auf den InP-Streifen (40, 41);
h) Erzeugen der zweiten elektronischen Bauelemente (61) mittels Lithographie und Ätzprozessen.

2. Verfahren nach Anspruch 1, dadurch gekennzeichnet, daß die erste Schichtenfolge (11-14) mittels einer der drei Epitaxieprozesse
- Gasphasenepitaxie (VPE)
- Flüssigphasenepitaxie (LPE)
- Molekularstrahlepitaxie (MBE)
hergestellt wird.

3. Verfahren nach Anspruch 1, dadurch gekennzeichnet, daß die semi-isolierende InP-Schicht (30) mittels einer der drei Epitaxieprozesse
- Gasphasenepitaxie (VPE)
- Flüssigphasenepitaxie (LPE)
- Molekularstrahlepitaxie (MBE)
hergestellt wird.

4. Verfahren nach Anspruch 1, dadurch gekennzeichnet, daß es sich bei den ersten elektronischen Bauelementen (60) um Doppel-Heterostrukturlaser handelt.

5. Verfahren nach Anspruch 1, dadurch gekennzeichnet, daß es sich bei den ersten elektronischen Bauelementen (60) um Pin-Photodioden handelt.

6. Verfahren nach Anspruch 1, dadurch gekennzeichnet, daß es sich bei den zweiten elektronischen Bauelementen (61) um Hetero-Bipolartransistoren (HBT) handelt.

7. Verfahren nach Anspruch 1, dadurch gekennzeichnet, daß es sich bei den zweiten elektronischen Bauelementen (61) um Feldeffekttransistoren handelt.

## Claims

1. A method of producing monolithic integrated, particularly optoelectronic, modules based on III/V compound semiconductors on which first and second electronic components (60, 61) are provided, said method comprising the following steps:
a) epitaxially depositing a first succession of semiconductor layers (11-14) for first electronic components over the entire surface of a semi-insulating or conducting InP substrate (10);
b) forming a first electronic component by covering a portion of the first succession of semiconductor layers (11-14) with a first dielectric layer (15), and
c) etching away the uncovered portion of the first succession of semiconductor layers (11-14), leaving a layered mesa structure (20) under the first dielectric layer (15), the latter forming overhangs (21, 22);
d) selectively epitaxially depositing a semi-insulating InP layer (30), with the first dielectric layer (15) acting as a mask, until the InP layer (30) and the layered mesa structure (20) of the portion of the first succession of semiconductor layers form a flat surface;
e) covering the portion of the first succession of semiconductor layers with a second dielectric layer (16) which extends a given distance beyond the portion of the first succession of semiconductor layers;
f) partially etching away the uncovered semi-insulating InP layer (30), leaving InP stripes (40, 41) with a flat surface, the second dielectric layer forming overhangs (42, 43);
g) selectively epitaxially depositing a second succession of semiconductor layers(51-53) for second electronic components on the InP stripes (40, 41);
h) forming the second electronic components (61) by lithographic and etching processes.

2. A method as claimed in claim 1, characterized in that the first succession of layers (11-14) is formed by one of the three epitaxial processes
- vapor phase epitaxy (VPE)
- liquid-phase epitaxy (LPE)
- molecular beam epitaxy (MBE).

3. A method as claimed in claim 1, characterized in that the semi-insulating InP layer is formed by one of the three epitaxial processes
- vapor phase epitaxy (VPE)
- liquid-phase epitaxy (LPE)
- molecular beam epitaxy (MBE).

4. A method as claimed in claim 1, characterized in that the first electronic components (60) are double-heterostructure lasers.

5. A method as claimed in claim 1, characterized in that the first electronic components (60) are PIN photodiodes.

6. A method as claimed in claim 1, characterized in that the second electronic components (61) are hetero-bipolar transistors (HBTs).

7. A method as claimed in claim 1, characterized in that the second electronic components (61) are field-effect transistors.

## Revendications

1. Procédé de fabrication de modules, en particulier opto-électroniques, intégrés en mode monolithique, constitués de semi-conducteurs composés III/V, sur lesquels se trouvent des premiers et des seconds composants électroniques (60, 61), procédé qui présente les pas suivants:
a) dépôt épitaxial, sur toute la surface, d'une première succession de couches de semi-conducteur (11-14) pour des premiers composants électroniques sur un substrat InP (10) semi-isolant ou conducteur;
b) réalisation d'un premier composant électronique par couverture d'une zone partielle de la première succession de couches de semi-conducteur (11-14) avec une première couche diélectrique (15), et
c) élimination, par attaque, de la zone non recouverte de la première succession de couches de semi-conducteur (11-14) à l'exception d'une structure de couche (20) de forme mésa subsistant sous la première couche diélectrique (15), la première couche diélectrique formant des dépassements (21, 22);
d) dépôt épitaxial sélectif d'une couche InP semi-isolante (30) avec la première couche diélectrique (15) comme masque, jusqu'à ce que la couche InP (30) et la couche de structure de forme mésa (20) de la première zone partielle forment une surface plane;
e) couverture de la première zone partielle avec une seconde couche diélectrique (16) qui dépasse d'une longueur déterminée au-delà de la première zone partielle;
f) élimination partielle, par attaque, de la couche InP semi-isolante (30) non recouverte. à l'exception des rubans InP subsistants (40, 41)à surface plane, la seconde couche diélectrique formant des dépassements (42, 43);
g) dépôt épitaxial sélectif, sur les rubans InP (40, 41), d'une seconde succession de couches à semi-conducteur (51-53) pour des seconds composants électroniques;
h) production des seconds composants électroniques (61) par lithographie et processus d'attaque.

2. Procédé selon la revendication 1, caractérisé par le fait qu'on réalise la première succession de couches (11-14) au moyen de l'un des trois processus épitaxiaux
- épitaxie en phase gazeuse (VPE)
- épitaxie en phase liquide (LPE)
- épitaxie par faisceau moléculaire (MBE).

3. Procédé selon la revendication 1, par le fait qu'on réalise la couche InP semi-isolante (30) au moyen de l'un des trois processus épitaxiaux
- épitaxie en phase gazeuse (VPE)
- épitaxie en phase liquide (LPE)
- épitaxie par faisceau moléculaire (MBE).

4. Procédé selon la revendication 1, caractérisé par le fait qu'en ce qui concerne les premiers composants électroniques (60), il s'agit de lasers de structure à hétérojonction double.

5. Procédé selon la revendication 1, caractérisé par le fait qu'en ce qui concerne les premiers composants électroniques (60), il s'agit de photodiodes PIN.

6. Procédé selon la revendication 1, caractérisé par le fait qu'en ce qui concerne les seconds composants électroniques (61), il s'agit de transistors bipolaires à hétérojonction (HBT).

7. Procédé selon la revendication 1, caractérisé par le fait qu'en ce qui concerne les seconds composants électroniques (61), il s'agit de transistors à effet de champ.
